# EUROPEAN PATENT APPLICATION

(11) **EP 2 375 877 A2**
(43) Date of publication of application: **12.10.2011**
(21) Application number: 11161268.5
(22) Date of filing: 06.04.2011
(51) Int. Cl.: H05K 1/02, H05K 1/16, H05K 1/18, H02H 9/04, H01H 57/00

(54) **Planar voltage protection assembly**

(30) Priority: 06.04.2010 US 341953 P; 22.03.2011 US 53729
(71) Applicant: Tyco Electronics Corporation, Berwyn, PA 19312 (US)
(72) Inventor: Harrison, William, El Dorado Hills, CA 95762 (US); Dalmia, Sidharth, Fair Oakes, CA 95628 (US); Das, Jaydip, Sunnyvale, CA 94086 (US)
(74) Representative: Ashton, Gareth Mark

(57) **Abstract**

A voltage protection assembly (100) comprises a planar substrate (102) having a thickness dimension (300) that vertically extends from an upper surface (304) of the substrate to an opposite lower surface (302) of the substrate. The substrate includes one or more conductive traces (104). The voltage protection assembly comprises a conductive input terminal (106) conductively coupled with at least one of the conductive traces, and a conductive output terminal (108) conductively coupled with at least one of the conductive traces. The output terminal, an inductive element (120), a capacitive element (118, 600), and the input terminal are connected in series by the conductive traces to form a voltage protection circuit (110, 112) that filters one or more frequencies of a data signal transmitted through the voltage protection circuit. At least one of the capacitive element (118, 600) and the inductive element (120) are entirely disposed within the thickness dimension (300) of the substrate.

## Description

The invention relates to electronic devices such as transformers, inductors, filters, or chokes.

Electronic devices can require protection from excessive voltages and/or energy in electric current that is transmitted to the devices. For example, Ethernet devices that receive data communications from a transmitting device may include voltage and/or energy sensitive components that may be damaged if a received current has excessive voltage and/or energy. In order to protect the devices from excessive voltage and/or energy of the received current, some known devices are coupled with a transformer. The transformer can step down the voltage and/or energy of the received current. The transformer may be formed by winding a conductive wire around a ferrite body, such as an iron core.

These transformers are not without their shortcomings. For example, traditional transformers can be relatively large, especially in the context of Ethernet devices and other communication devices. When the size of the transformers is decreased, the relatively brittle ferrite bodies may be damaged and/or break during incorporation of the transformer into the communication device. Moreover, winding the wires around the ferrite bodies can become more difficult as the size of the transformer decreases.

Some known electronic devices may require filtering of relatively low and/or high frequency components of data signals that are transmitted to the devices. In order to provide such filtering, these devices may include additional filter components that are mounted on a circuit board, such as a printed circuit board, to which the electronic device is mounted or otherwise coupled. The mounting of the filter components to the board can increase the size of the device. As the need for smaller communication devices increases, the mounting of filtering components to the boards becomes more undesirable.

A need exists for an assembly that protects electronic components from excessive voltage and/or energy, and/or filters data signals communicated to the components, while keeping the size of the assembly relatively small.

This problem is addressed by a voltage protection assembly according to any one of the appended claims.

According to an embodiment of the invention, a voltage protection assembly comprises a planar substrate having a thickness dimension that vertically extends from an upper surface of the substrate to an opposite lower surface of the substrate. The substrate includes one or more conductive traces. A conductive input terminal is disposed on the substrate and conductively coupled with at least one of the conductive traces. A capacitive element is electrically coupled with the input terminal by at least one of the conductive traces. An inductive element is conductively coupled with the capacitive element by at least one of the conductive traces. A conductive output terminal is disposed on the substrate and conductively coupled with the inductive element by at least one of the conductive traces. The output terminal, the inductive element, the capacitive element, and the input terminal are connected in series to form a voltage protection circuit that filters one or more frequencies of a data signal transmitted through the voltage protection circuit. At least one of the capacitive element or the inductive element is entirely disposed within the thickness dimension of the substrate. Optionally, the thickness dimension of the substrate may be 2.5 millimeters or less.

Embodiments of the invention will now be described by way of example and with reference to the accompanying drawings, in which:

Figure 1 is a schematic view of a planar voltage protection assembly in accordance with one embodiment.

Figure 2 is a top view of one embodiment of the voltage protection assembly shown in Figure 1.

Figure 3 is a cross-sectional view of the voltage protection assembly along line 3-3 in Figure 2.

Figure 4 is a circuit diagram of one embodiment of the voltage protection assembly shown in Figure 1 in a normal operating state.

Figure 5 is a circuit diagram of one embodiment of the voltage protection assembly shown in Figure 1 in an overvoltage or overcurrent operating state.

Figure 6 is a schematic diagram of an ESD switch in accordance with an alternative embodiment.

Figure 7 is another schematic diagram of the ESD switch shown in Figure 6.

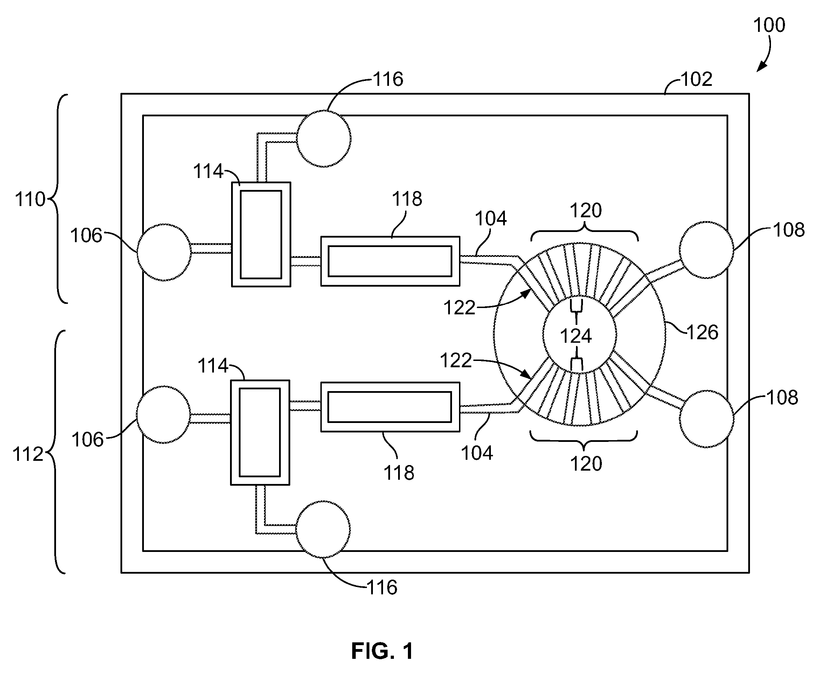

Figure 1 is a schematic view of a planar voltage protection assembly 100 in accordance with one embodiment. The assembly 100 includes a planar substrate 102 having several conductive traces 104. By "planar," it is meant that the substrate 102 is larger along two perpendicular directions than in a third perpendicular direction. The substrate 102 may be a flexible and non-rigid sheet, such as a sheet of cured epoxy, or a rigid or semi-rigid board, such as a printed circuit board (PCB) formed of FR-4. The conductive traces 104 are conductive pathways that connect several components of the assembly 100 in the substrate 102. The conductive traces 104 may be deposited onto the substrate 102 and/or may be embedded in the substrate 102. For example, the substrate 102 may be a multi-layered PCB with the conductive traces 104 deposited onto one or more of the layers of the PCB.

The assembly 100 includes two conductive input terminals 106 and two conductive output terminals 108 in the illustrated embodiment. Alternatively, the assembly 100 may include a different number of input terminals 106 and/or output terminals 108. The input terminals 106, the output terminals 108, and the conductive traces 104 are electrically conductive bodies that include, or are formed from, metal or metal alloys, such as copper. The conductive traces 104 conductively couple the input terminals 106 with the output terminals 108 and several additional components described below. The input terminals 106 and/or the output terminals 108 can be formed as conductive pads disposed on an exterior surface of the substrate 102. Alternatively, the input terminals 106 and/or the output terminals 108 can be formed as conductive terminals that protrude from the substrate 102 or conductive receptacles disposed in the substrate 102. The input terminals 106 can engage or mate with conductive bodies of a data transmitting device, such as with wires or a bus in a circuit board, and the output terminals 108 can engage or mate with conductive bodies of a data receiving device, such as with wires or busses that are connected with an integrated circuit (IC). For example, the assembly 100 may be disposed on a circuit board with an IC, and data signals communicated to the IC may be transmitted through the assembly 100 before reaching the IC. The assembly 100 can be integrated into electrical connectors, such as RJ-45 connectors, that are used for Ethernet-type applications. For example, the assembly 100 may be used in an RJ-45 connector used for Ethernet communications. When the assembly 100 is integrated into such connectors, the assembly 100 can allow for easier use of the assembly 100 and can improve the electrical performance of the connector.

In the illustrated embodiment, the assembly 100 includes two voltage protection circuits 110, 112, with each voltage protection circuits 110, 112 including one of the input terminals 106 conductively coupled with one of the output terminals 108 by one or more conductive traces 104. Data, such as high speed data communicated at rates of at least 10 megabits per second, can be communicated along the voltage protection circuits 110, 112 from the input terminals 106 to the output terminals 108. The voltage protection circuits 110, 112 shown in Figure 1 communicate differential data signals. For example, the voltage protection circuit 110 can transmit a positive portion of a high speed differential data signal while the voltage protection circuit 112 transmits a complementary negative portion of the high speed differential data signal. Alternatively, the voltage protection circuits 110, 112 may communicate non-differential data signals, such as single-ended signals. While two voltage protection circuits 110, 112 are shown in the assembly 100, the assembly 100 may include a single voltage protection circuit 110 or 112, or more than two voltage protection circuits 110, 112.

The voltage protection circuits 110, 112 provide overcurrent or overvoltage protection for the data receiving device, such as an IC. In one embodiment, the voltage protection circuits 110, 112 protect the data receiving device from electric current having an energy that exceeds a predetermined threshold energy. For example, the voltage protection circuits 110, 112 may block current having too high of a voltage from passing from the input terminal 106 to the output terminal 108. The voltage protection circuits 110, 112 provide this overcurrent or overvoltage protection without use of a transformer in or on the substrate 102 in one embodiment. For example, the voltage protection circuits 110, 112 may not include a transformer disposed between and conductively coupled with the input terminal 106 and output terminal 108 of the respective voltage protection circuit 110, 112. By use of the term "transformer," it is meant that, in one embodiment, the voltage protection circuits 110, 112 do not include a device or component that transfers electric energy from a first circuit to a different second circuit that is conductively coupled with the first circuit through inductively coupled conductors or coils. The voltage protection circuits 110, 112 may each include a conductive pathway that extends from the input terminal 106 to the output terminal 108 such that data signals can be communicated through the voltage protection circuits 110, 112 without being inductively transferred between conductors within the respective voltage protection circuit 110, 112.

The assembly 100 can include conductive ground terminals 116 that are conductively coupled with the voltage protection circuits 110, 112 by the conductive traces 104. The ground terminals 116 are electrically conductive bodies that include, or are formed from, metal or metal alloys, such as copper. The ground terminals 116 can be formed as conductive pads disposed on an exterior surface of the substrate 102. Alternatively, the ground terminals 116 can be formed as conductive terminals that protrude from the substrate 102 or conductive receptacles disposed in the substrate 102. The ground terminals 116 can engage or mate with conductive bodies that are conductively coupled with an electric ground reference, such as a reference point in the voltage protection circuits 110, 112 from which other voltages are measured, a common return path for electric current such as a chassis, or a direct physical connection to the earth.

In the illustrated embodiment, the voltage protection circuits 110, 112 may include electrostatic discharge (ESD) switches 114. The ESD switches 114 are conductively coupled with the input terminals 106 of the respective voltage protection circuit 110, 112 by one or more of the conductive traces 104. The ESD switches 114 also may be conductively coupled with the ground terminals 116. The ESD switches 114 conductively couple the input terminals 106 with additional components of the voltage protection circuits 110, 112 and prevent current from flowing to the ground terminals 116 when the energy of the current flowing through the voltage protection circuits 110, 112 does not exceed a predetermined threshold. However, when the energy of the current does exceed the threshold, the ESD switches 114 may open the conductive pathway between the input terminals 106 and the additional components of the voltage protection circuits 110, 112 and conductively couple the input terminals 106 with the ground terminals 116. For example, when the signals being conveyed through one or more of the voltage protection circuits 110, 112 includes a voltage spike or other aberration, the ESD switches 114 may open the conductive pathway over which the signals are normally conveyed through the voltage protection circuits 110, 112 and direct the signals to the ground reference via the ground terminals 116. The ESD switches 114 may transition back to conveying the signals through the voltage protection circuits 110, 112 and to the output terminals 108 when the energy of the signals reduces to below the thresholds of the ESD switches 114.

The assembly 100 includes capacitive elements 118 in each of the voltage protection circuits 110, 112 in the illustrated embodiment. The capacitive elements 118 include one or more capacitors that are electrically coupled with the ESD switch 114 of the respective voltage protection circuit 110, 112 by one or more of the conductive traces 104. Alternatively, in an embodiment where the ESD switches 114 are not included in the voltage protection circuits 110, 112, the capacitive elements 118 may be conductively coupled with the input terminals 106 by one or more of the conductive traces 104.

In one embodiment, the capacitive elements 118 are disposed in series with inductive elements 120 in each of the voltage protection circuits 110, 112. The capacitive elements 118 may have a capacitance characteristic that causes the capacitive elements 118 to act as high pass filters. For example, the capacitive elements 118 may cut-off, or remove, portions of the data signals communicated through the voltage protection circuits 110, 112 having frequencies that are below a cut-off frequency. In one embodiment, the capacitive elements 118 have 3db cut-off frequencies of 10s of KHz. Alternatively, the capacitive elements 118 may have a different cut-off frequency. The capacitance value of the capacitive elements 118 may be in the range of 0.5 nanoFarads to 10 nanoFarads with a leakage current of 10 microAmps to 700 microAmps when the voltage of the current conveyed through the capacitive elements is between 1500 volts to 2500 volts. The capacitive elements 118 may have relatively high voltage breakdowns. For example, the capacitive elements 118 may not breakdown until the voltage of the data signals flowing through the capacitive elements 118 is at least 2500 volts or greater. Alternatively, the capacitive elements 118 may have larger breakdown voltages. For example, the breakdown voltage may be between 1000 and 3000 volts per mil (or 39,370 and 118,110 volts per millimeter).

In one embodiment, the capacitive elements 118 include multilayer ceramic capacitors or multilayer polymer-based capacitors. In one embodiment, one or more of the capacitive elements 118 is a 20 layer capacitor having parallel conductive plates of approximately 6 millimeters by 4 millimeters. The plates of the capacitive elements 118 can form parts of the layers of the substrate 102. For example, where the substrate 102 is a circuit board having several dielectric layers vertically stacked on top of each other, the conductive plates of the capacitive elements 118 may be formed as conductive traces or portions of the layers in the substrate 102. Using materials such as ceramic loaded polymers, thermoplastics, hydrocarbons, and the like, to form the capacitive elements 118 can provide a capacitive density of 2 to 4, or 2 to 10, picoFarads per square millimeter with a breakdown voltage of 2000 volts per mil (or 2000 volts per 25.4 micrometer) or greater.

The capacitive elements 118 may have relatively small dimensions. For example, each capacitive element 118 may have physical dimensions of 0.5 millimeters by 0.25 millimeters by 0.2 millimeters or smaller. Alternatively, each capacitive element 118 may be larger, such as a capacitive element 118 having physical dimensions of 4.5 millimeters by 3.2 millimeters by 2.0 millimeters.

The assembly 100 includes inductive elements 120 in each of the voltage protection circuits 110, 112 in the illustrated embodiment. The inductive elements 120 include one or more inductors that are conductively coupled with the capacitive elements 118 and the output terminal 108 of the respective voltage protection circuit 110, 112 by one or more of the conductive traces 104. As shown in Figure 1, the inductive elements 120 may be disposed downstream from the capacitive elements 118 along the direction of data flow through the voltage protection circuits 110, 112 from the input terminals 106 to the output terminals 108. For example, the capacitive elements 118 may be disposed between the input terminals 106 and the inductive elements 120 and the inductive elements 120 may be disposed between the capacitive elements 118 and the output terminals 108. Alternatively, the inductive elements 120 may be disposed upstream of the capacitive elements 118 along the direction of data flow through the voltage protection circuits 110, 112. While only a single inductive element 120 is shown in each of the voltage protection circuits 110, 112, alternatively, additional inductive elements 120 may be joined in series with the illustrated inductive elements 120.

In the illustrated embodiment, the inductive elements 120 are formed as conductive coils 122 that are joined with the capacitive elements 118 and the output terminals 108 by the conductive traces 104. The conductive coils 122 include several turns 124 that encircle a common ferrite body 126. For example, the conductive coils 122 of the voltage protection circuit 110 encircle the ferrite body 126 and the conductive coils 122 of the voltage protection circuit 112 encircle the same ferrite body 126. Alternatively, the conductive coils 122 of the inductive elements 120 may be wrapped around different ferrite bodies 126. The ferrite body 126 is shown in Figure 1 as having a shape of a toroid, but alternatively may have another shape. The conductive coils 122 carry data signals from the capacitive elements 118 to the output terminals 108. The conductive coils 122 of the voltage protection circuits 110, 112 are wrapped around the same ferrite body 126 to form a choke device. The choke device filters high frequency common mode signals which can degrade differential data conveyed through the voltage protection circuits 110, 112 in one embodiment.

The voltage protection circuits 110, 112 may not communicate data signals between each other through the choke device provided by the inductive elements 120 and the ferrite body 126 in one embodiment. For example, the voltage protection circuit 110 may not inductively convey a data signal to the voltage protection circuit 112 via the ferrite body 126, and vice-versa. As described above, in one embodiment, the assembly 100 provides overcurrent and/or overvoltage protection without including a transformer. Moreover, the voltage of the data signals conveyed along each of the voltage protection circuits 110, 112 may not be stepped up or stepped down by the choke device that includes the inductive elements 120 and the common ferrite body 126.

The inductive elements 120 may be selected so as to control the lower cut-off frequency of the common mode energy out of voltage protection circuits 110, 112. For example, inductive elements 120 having different inductive characteristics and/or physical characteristics (e.g., number of turns 124 around the ferrite body 126) may prevent different frequencies of common mode energy from passing through the inductive elements 120. As shown in Figure 1, the ESD switches 114, the capacitive elements 118, and the inductive elements 120 of each of the voltage protection circuits 110, 112 are conductively coupled in series with each other between the input terminals 106 and the output terminals 108. The voltage protection circuits 110, 112 can provide overvoltage and/or overcurrent protection and frequency filters for an electronic device coupled with the output terminals 108 and receiving data signals from a communication device coupled with the input terminals 106. The voltage protection circuits 110, 112 can provide the above protections and filters without use of a transformer component in or between the voltage protection circuits 110, 112.

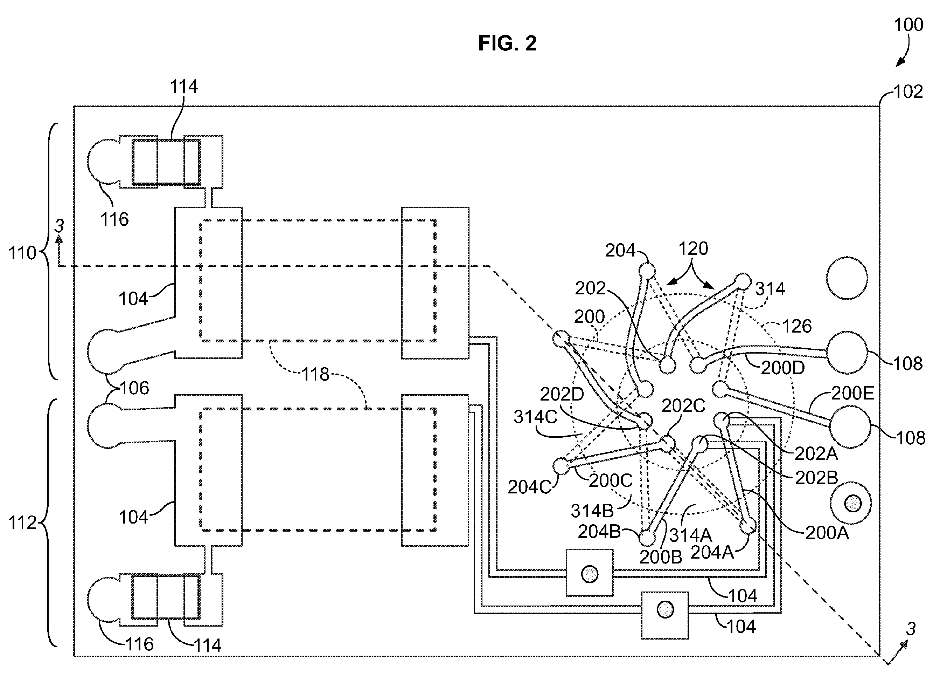

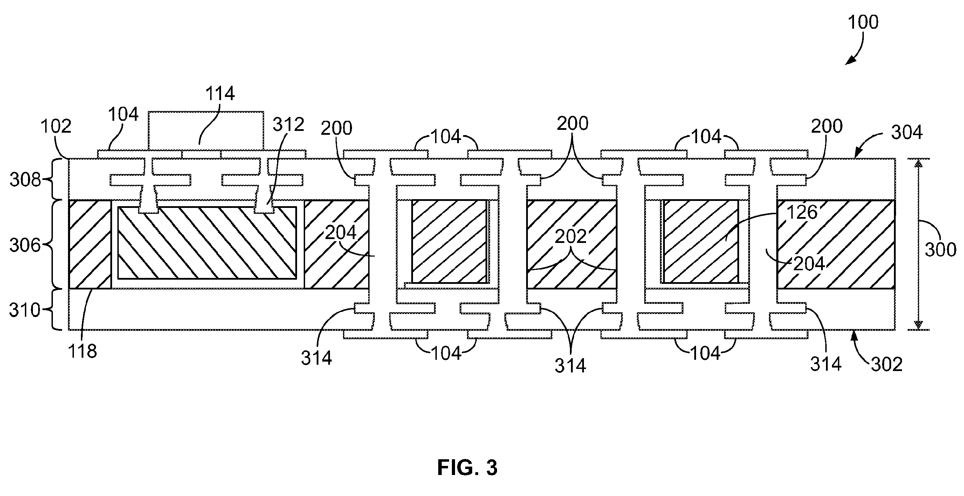

Figure 2 is a top view of one embodiment of the voltage protection assembly 100. Figure 3 is a cross-sectional view of the voltage protection assembly 100 along line 3-3 in Figure 2. The substrate 102, the ESD switches 114, and the capacitive elements 118 are shown in phantom in Figure 2 to more clearly illustrate the relative locations of the various components of the assembly 100. While the cross-sectional line 3-3 extends through two obliquely oriented planes of the assembly 100 in Figure 3, alternatively, the cross-sectional line 3-3 may extend through only a single plane of the assembly 100.

The substrate 102 is a planar body having a thickness dimension 300 (shown in Figure 3) that vertically extends from a lower surface 302 (shown in Figure 3) to an upper surface 304 (shown in Figure 3). In one embodiment, the thickness dimension 300 is 3.0 millimeters or less. Alternatively, the thickness dimension 300 may be 2.5 millimeters or less. In another embodiment, the thickness dimension 300 is 1.0 millimeter or less. The substrate 102 may include a center layer 306 having an upper outer layer 308 and a lower outer layer 310 disposed on opposite sides of the center layer 306. The center layer 306 can be a flexible and non-rigid body, such as a layer of cured epoxy, while the outer layers 308, 310 can be non-flexible and rigid bodies, such as cured FR-4 material. In the illustrated embodiment, the conductive traces 104 are disposed on and/or within the outer layers 308, 310 but not within the center layer 306. Alternatively, the conductive traces 104 can extend through the center layer 306. In another embodiment, the substrate 102 can be a single, unitary body formed from a single material or type of material.

The input terminals 106 (shown in Figure 2) and the ground terminals 116 (shown in Figure 2) are formed as conductive pads disposed on the upper surface 304 of the substrate 102 in Figure 2. As shown in Figure 2, the conductive traces 104 electrically couple the ESD switches 114 and the capacitive elements 118 in parallel with each other in each of the voltage protection circuits 110, 112 (shown in Figure 2). Alternatively, the ESD switches 114 and the capacitive elements 118 may be disposed in series with each other.

The ESD switches 114 are mounted to the upper surface 304 (shown in Figure 3) of the substrate 102 in the illustrated embodiment. For example, the ESD switches 114 may be conductively coupled with the conductive traces 104 using one or more interconnections, such as a wire bond and/or solder ball connection. Alternatively, the ESD switches 114 may be entirely disposed within the substrate 102. For example, the ESD switches 114 can be located within the thickness dimension 300 (shown in Figure 3) of the substrate 102 such that no part of the ESD switches 114 protrudes above, breaks, or passes through a plane defined by the upper surface 304 of the substrate 102 or a plane defined by the lower surface 302 (shown in Figure 3) of the substrate 102.

In one embodiment, the ESD switches 114 include or are formed from a voltage switchable dielectric (VSD) material, such as one or more of the Voltage Switchable Dielectric™ devices provided by Shocking Technologies. The VSD material may be a polymer nano-composite that behaves like an electrically insulative material (e.g., a dielectric) during normal operation. For example, the VSD material does not conduct electric current when the voltage or energy of the current remains at or below a threshold. The VSD material becomes conductive when the voltage or energy of the current exceeds the threshold. The VSD material returns to an insulative or non-conductive state when the voltage or energy of the current flowing through the VSD material decreases below the threshold. Alternatively, the ESD switches 114 may be another type of switch that opens or closes the conductive pathway or circuit with the ground terminals 116 (shown in Figure 2) when the voltage or energy of current flowing through the voltage protection circuits 110, 112 (shown in Figure 2) exceeds the thresholds of the ESD switches 114.

The capacitive elements 118 are entirely disposed within the substrate 102 in the illustrated embodiment. For example, as shown in Figure 3, the capacitive elements 118 can be located within the thickness dimension 300 of the substrate 102 such that the capacitive elements 118 are entirely located within the center layer 306 of the substrate 102 and no part of the capacitive elements 118 extends into either of the outer layers 308, 310 of the substrate 102. For example, no part of the capacitive elements 118 may protrude above, break, or pass through a plane defined by an interface between the center layer 306 and the upper outer layer 308 and/or an interface between the center layer 306 and the lower outer layer 310. Alternatively, the capacitive elements 118 may be mounted onto the substrate 102, such as by being conductively coupled with the upper surface 304 of the substrate 102.

The capacitive elements 118 disposed within the substrate 102 are conductively coupled with the conductive traces 104 disposed within the outer layers 308, 310 (shown in Figure 3) of the substrate 102 and/or the conductive traces 104 disposed on the upper surface 304 (shown in Figure 3) of the substrate 102 by conductive vias 312 in the illustrated embodiment. The vias 312 can be holes or channels that are plated with a conductive material or substantially filled with a conductive material, such as copper. The vias 312 may vertically extend through all or a portion of the thickness dimension 300 of the substrate 102. In one embodiment, the vias 312 are conductively coupled with conductive plates or electrodes in the capacitive elements 118. For example, in an embodiment where the capacitive elements 118 are monolithic ceramic capacitors having two electrodes disposed apart by one or more dielectric sheets, each via 312 may be conductively coupled with a different electrode of the capacitive element 118.

In one embodiment, the capacitive elements 118 and/or the inductive elements 120 are embedded in the center layer 306 of the substrate 102 using predrilled or preformed cavities or openings in the center layer 306. For example, the center layer 306 may be formed with one or more openings or have the openings drilled into the center layer 306 with the capacitive element 118 and/or the inductive element 120 positioned in the openings. The capacitive element 118 and/or the inductive element 120 can then be enclosed or surrounded by a flexible, elastic epoxy material within the center layer 306. In one embodiment, the capacitive element 118 and/or the inductive element 120 may be embedded in the substrate 102 using one or more methods disclosed in U.S. Patent Application No. 12/592,771, which is entitled "Manufacture And Use Of Planar Embedded Magnetics As Discrete Components And In Integrated Connectors" and was filed on December 1, 2009 (the "'771 Application"). The entire disclosure of the '771 Application is incorporated by reference herein in its entirety.

For example, the capacitive element 118 and/or inductive element 120 may be embedded into the substrate 102 in a manner similar to fabricating the planar transformer (200) of the '771 Application. In one embodiment, as described in the '771 Application, a borehole (1102 of the '771 Application) is disposed in the substrate 102 and the capacitive element 118 or the inductive element 120 is enveloped in an elastic and non-conductive material (1108 of the '771 Application) within the substrate 102. A top conductor (1110 of the '771 Application) and a bottom conductor (1112 of the '771 Application) can be bonded to the substrate 102 surfaces using an insulating adhesive (1114 of the '771 Application). Through holes (1116 of the '771 Application) are drilled through the top conductor (1110 of the '771 Application), a top bonding layer (1114 of the '771 Application), an elastic and non-conductive material (1108 of the '771 Application), the substrate 102, a bottom bonding layer (1114 of the '771 Application), and the bottom conductor (1112 of the '771 Application). The through holes (1116 of the '771 Application) are cleaned and metal-coated to create conductive vias (1118 of the '771 Application). The conductive vias (1118 of the '771 Application) may provide conductive pathways into and out of the capacitive element 118 and/or the inductive element 120.

As shown in Figure 2, the conductive traces 104 electrically couple the capacitive elements 118 with the inductive elements 120. The inductive elements 120 are formed as the conductive coils 122 (shown in Figure 1) that encircle the ferrite body 126. The conductive coils 122 include upper conductive layers 200 and lower conductive layers 314 joined by conductive inner vias 202 and/or conductive outer vias 204. The upper conductive layers 200 and the ferrite body 126 are shown in phantom view in Figure 2 so that the lower conductive layers 314 are visible. In one embodiment, one or more of the upper conductive layers 200, the lower conductive layers 314, the inner vias 202, and/or the outer vias 204 may be formed in accordance with the description of the '771 Application. For example, the upper conductive layers 200 may be provided similar to the top conductive layers 1110 in the '771 Application, the lower conductive layers 314 may be provided similar to the bottom conductive layers 1112 in the '771 Application, and/or the inner or outer vias 202, 204 may be provided similar to the vias 1118 of the '771 Application.

The upper and lower conductive layers 200, 314 may be formed as conductive traces disposed within the thickness dimension 300 of the substrate 102. For example, as shown in Figure 3, the upper and lower conductive layers 200, 314 may be disposed within the outer layers 308, 310 of the substrate 102. Alternatively, the upper and/or lower conductive layers 200, 314 may be disposed on the substrate 102. The upper and lower conductive layers 200, 314 are conductively coupled with the conductive traces 104 by the vias 202, 204. Holes or channels can be drilled through the thickness dimension 300 (shown in Figure 3) of the substrate 102 from the lower surface 302 (shown in Figure 3) to the upper surface 304 (shown in Figure 3). The holes or channels can be plated or filled with a conductive material, such as a metal or conductive solder, to form the vias 202, 204.

Several inner vias 202 and several outer vias 204 are provided on opposite sides of the ferrite body 126. For example, with respect to the toroid-shaped ferrite body 126 shown in the illustrated embodiment, the inner vias 202 are surrounded by the ferrite body 126 and several outer vias 204 are located outside of the ferrite body 126. In the illustrated embodiment, each of the upper conductive layers 200 extends from one of the outer vias 204 to one of the inner vias 202 to conductively couple the outer via 204 with the inner via 202. Similar to the upper conductive layers 200, each of the lower conductive layers 314 (shown in Figure 3) extends from one of the outer vias 204 to one of the inner vias 202 to conductively couple the outer via 204 with the inner via 204.

The conductive coils 122 of the inductive elements 120 helically wrap around the ferrite body 126. The conductive coils 122 of the different inductive elements 120 are formed by different combinations of conductively coupled vias 202, 204, upper conductive layers 200, and lower conductive layers 314. As shown in Figure 2, different upper conductive layers 200 are labeled as the upper conductive layers 200A, 200B, 200C, and so on, different lower conductive layers 314 are labeled as the lower conductive layers 314A, 314B, 314C, and so on, different inner vias 202 are labeled as the inner vias 202A, 202B, 202C, and so on, and different outer vias 204 are labeled as the outer vias 204A, 204B, 204C, and so on. The conductive coil 122 of the inductive element 120 for the voltage protection circuit 110 includes one of the conductive traces 104 joined with the inner via 202A, which is coupled with the upper conductive layer 200A, which is joined with the outer via 204A, which is joined with the lower conductive layer 314A, which is joined with the inner via 202C, which is joined with the upper conductive layer 200C, and so on, to the upper conductive layer 200D, which is joined with the outlet terminal 108. The conductive coil 122 of the inductive element 120 for the other voltage protection circuit 112 includes one of the conductive traces 104 joined with the inner via 202B, which is coupled with the upper conductive layer 200B, which is joined with the outer via 204B, which is joined with the lower conductive layer 314B, which is joined with the inner via 202D, and so on, to the upper conductive layer 200E, which is joined with the outlet terminal 108. As shown in Figure 2, the conductive coils 122 each helically wrap around the ferrite body 126 while intertwined or interleaved with each other, without the conductive coils 122 engaging or contacting each other.

The inductive elements 120 can be entirely disposed within the thickness dimension 300 of the substrate 102. For example, the inductive elements 120 can include the ferrite body 126, the vias 202, 204, and the upper and lower conductive layers 200, 314, where none of the ferrite body 126, the vias 202, 204, or the upper or lower conductive layers 200, 314 extend or project through the planes defined by the upper surface 304 and the lower surface 302 of the substrate 102. Alternatively, the inductive elements 120 may project through one or more of the planes defined by the upper and lower surfaces 304, 302.

In the voltage protection circuits 110, 112 shown in Figure 2, each voltage protection circuit 110, 112 includes the input terminal 106, the capacitive element 118, the inductive element 120, and the outlet terminal 108 conductively joined in series with each other and the ESD switch 114 joined in parallel with the capacitive element 118. The ESD switches 114 can protect an electronic device that is coupled with the voltage protection circuits 110, 112 from excessive voltages, while the capacitive elements 118 and the inductive elements 120 shape the signals conveyed along the voltage protection circuits 110, 112 by removing high and/or low frequency components of the signals. The voltage protection circuits 110, 112 provide the above over current and/or overvoltage protection and signal shaping functions without use of a transformer embedded in or mounted to the substrate 102, or otherwise conductively coupled with either voltage protection circuit 110, 112.

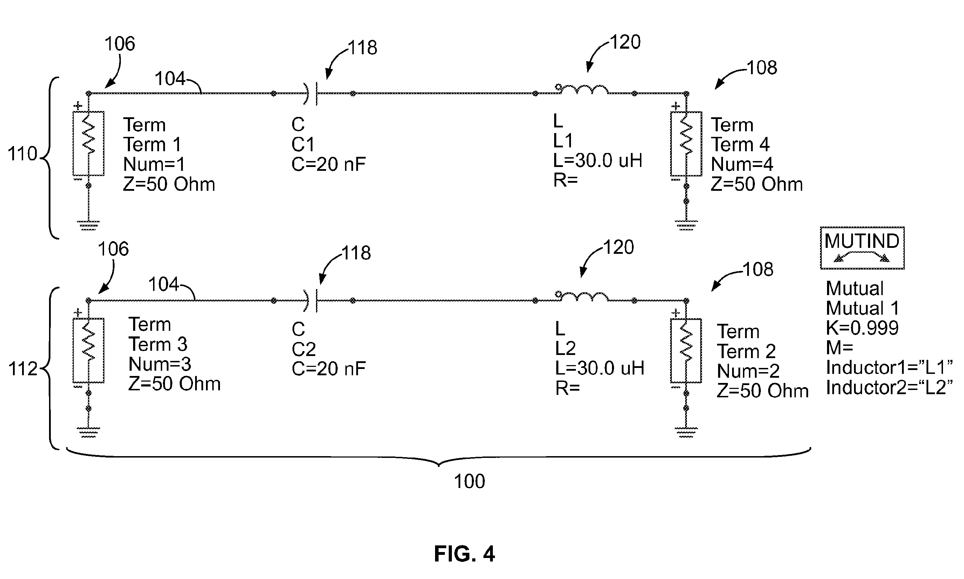

Figure 4 is a circuit diagram of one embodiment of the voltage protection assembly 100 in a normal operating state. By "normal operating state," it is meant that the circuit diagram shown in Figure 4 represents the assembly 100 when the voltage and/or energy of the current being conveyed through the voltage protection circuits 110, 112 does not exceed the threshold associated with the ESD switches 114 (shown in Figure 1). Each of the voltage protection circuits 110, 112 includes the capacitive element 118 and the inductive element 120 disposed in series with each other between the input terminal 106 and the output terminal 108. While some values are shown in Figure 4 for various electronic characteristics of the components in the assembly 100, the values shown are merely examples and are not intended to be limiting on all embodiments described herein. One or more other or different values may be used.

Data signals are transmitted to the input terminals 106. As described above, the data signals may be differential data signals with each voltage protection circuit 110, 112 conveying one of the differential data signals. For example, the data signals may be signals used in Ethernet communications, telephony communications, DSL communications, cable communications, and the like. The data signals are communicated along the conductive traces 104 from the input terminals 106 to the capacitive elements 118. In the illustrated embodiment, the capacitive elements 118 have a capacitance of 20 nanoFarads. Alternatively, the capacitive elements 118 may have a different capacitance. As described above, the capacitive elements 118 may filter, or remove, low frequency components of the data signals.

The data signals are conveyed from the capacitive elements 118 to the inductive elements 120. As described above, the inductive elements 120 may be conductive coils 122 (shown in Figure 1) of a choke device. The inductive elements 120 filter out, or remove, high frequency components from the data signals. In one embodiment, the inductive elements 120 may have an inductance of 30 to 100 microHenries at relatively low frequencies of around 10KHz to 10MHz. Alternatively, the inductive elements 120 can have a different inductance. The data signals are transmitted from the inductive elements 120 to the outlet terminals 108. The data signals are conveyed from the outlet terminals 108 to one or more electronic components coupled with the outlet terminals.

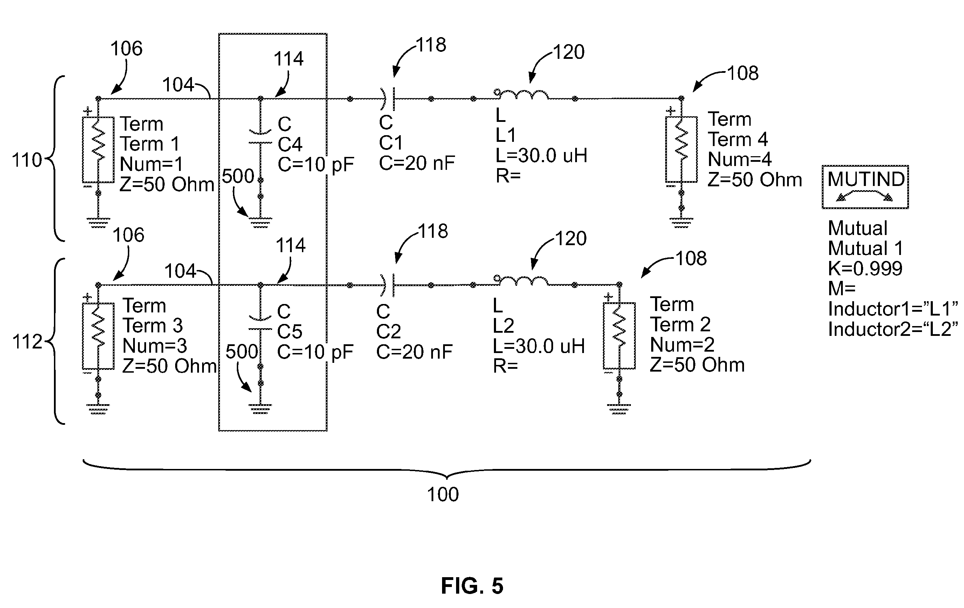

Figure 5 is a circuit diagram of one embodiment of the voltage protection assembly 100 in an overvoltage or overcurrent operating state. By "overvoltage or overcurrent operating state," it is meant that the circuit diagram shown in Figure 5 represents the assembly 100 when the voltage and/or energy of the current being conveyed through the voltage protection circuits 110, 112 exceeds the threshold associated with the ESD switches 114. While some values are shown in Figure 5 for various electronic characteristics of the components in the assembly 100, the values shown are merely examples and are not intended to be limiting on all embodiments described herein. One or more other or different values may be used.

Data signals having a voltage or energy that exceeds the threshold of the ESD switches 114 are transmitted to the input terminals 106. The data signals are communicated along the conductive traces 104 from the input terminals 106 to the ESD switches 114. In one embodiment, the current of the data signals converts the ESD switches 114 from a non-conductive material to a conductive material when the voltage and/or energy of the data signals exceeds the threshold of the ESD switches 114. The ESD switches 114 couple the conductive traces 104 with a ground reference 500 when the ESD switches 114 become conductive. For example, the ESD switches 114 may couple the conductive traces 104 to the ground terminal 116 (shown in Figure 1), which is coupled with Earth, a chassis, or another ground reference. The electric resistance of the pathway from the ESD switches 114 to the ground reference 500 may be less than the resistance of the conductive pathway from the ESD switches 114 to the outlet terminals 108. As a result, the data signals having the relatively high energy and/or voltage are conducted to the ground reference 500 instead of to the capacitive elements 118, the inductive elements 120, and the outlet terminals 108.

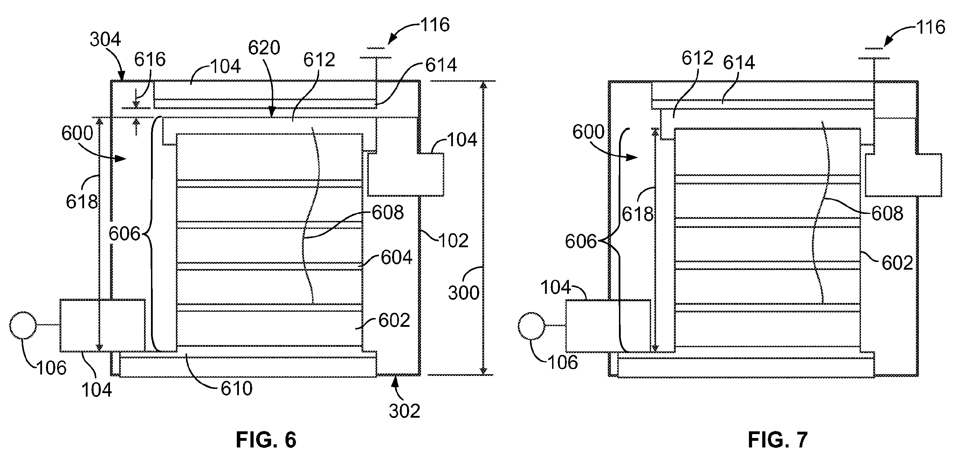

Figure 6 is a schematic diagram of a capacitive element 600 in accordance with an alternative embodiment. The capacitive element 600 may be used in place of, or in addition to, the capacitive element 118 (shown in Figure 1) described above, and can additionally act as an ESD switch. The capacitive element 600 includes a multilayer stack 606 of piezoelectric layers 602 separated by conductive layers 604. The stack 606 includes several piezoelectric layers 602 and conductive layers 604 vertically stacked on top of each other such that the conductive layers 604 do not contact or engage each other. A vertical conductive pathway 608, such as a wire, trace, or other conductive body, may extend vertically through the stack 606 and contact a plurality of the conductive layers 604 in the stack 606. For example, a first conductive pathway 608 may contact a first set of the conductive layers 604, such as every other conductive layer 604. A second conductive pathway 608 may contact a second, different set of the conductive layers 604, such as the conductive layers 604 that are not included in the first set. The stack 606 may form a multilayer or multiplate parallel capacitor element using the piezoelectric layers 602.

The stack 606 is disposed on a lower electrode 610. The lower electrode 610 is a conductive body that can be coupled with the input terminal 106 by one or more of the conductive traces 104. An upper electrode 612 is disposed on top of the stack 606. The upper electrode 610 is a conductive body that can be coupled with the inductive element 120 by one or more of the conductive traces 104. As shown in Figure 6, the conductive pathway 608 extends through the stack 606 and is conductively coupled with the upper electrode 612 but is separated from the lower electrode 610. A ground plate 614 is a conductive body that is disposed above the upper electrode 612. The ground plate 614 may be conductively coupled with the ground terminal 116 by one or more of the conductive traces 104. In normal operating condition, in the absence of high voltage, the effective capacitance of the stack 606 is between 0.1 nanoFarads to 10 nanoFarads.

The stack 606 has a vertical height dimension 618 that is measured from the interface between the stack 606 and the lower electrode 610 to an upper surface 620 of the upper electrode 612. In the illustrated embodiment, the vertical height dimension 618 is sufficiently small such that the upper electrode 612 is spaced apart and separated from the ground plate 614 by a separation gap 616. The separation gap 616 may be several micrometers long. The separation gap 616 is sufficiently large that electric current flowing through the upper electrode 612 does not jump to the ground plate 614 and short the voltage protection circuit 110, 112 (shown in Figure 1) that includes the ESD switch 600.

As shown in Figure 6, the capacitive element 600 may be disposed within the substrate 102. For example, the capacitive element 600 may be located within the thickness dimension 300 of the substrate 102 such that the capacitive element 600 (e.g., the upper electrode 612, the stack 606, and the lower electrode 610) does not break or project through the plane defined by the upper surface 304 of the substrate 102 or the plane defined by the lower surface 302 of the substrate 102.

In operation, electric current (e.g., data signals) is received by the lower electrode 610 from the input terminal 106 and the conductive trace 104 that is coupled with the lower electrode 610. The lowest conductive layer 604 is separated from the lower electrode 610 by at least one piezoelectric layer 602 to form a capacitive element. The current flows through the capacitive element formed by the lowest conductive layer 604 and the lower electrode 610 to the conductive pathway 608. The current flows through the stack 606 by being conveyed through the conductive pathway 608 and/or one or more of the conductive layers 604 to the upper electrode 612. The current flows to the conductive trace 104 that is coupled with the upper electrode 612. The capacitive element 600 shown in Figure 6 is in an open or "normal operation" state such that the capacitive element 600 does not couple the input terminal 106 with the ground terminal 116. For example, the vertical height dimension 618 is sufficiently small such that the upper electrode 612 does not conductively couple the conductive pathway 608 with the ground terminal 116 via the ground plate 614.

In one embodiment, the input terminals 106 may be connected to an auto-transformer, such as a transformer having a single winding. Portions of the single winding in the auto-transformer can act as both the primary coil or winding and the secondary coil or winding of a transformer having two coils or windings. The single winding of the auto-transformer has at least three taps, or points of connection, where electrical connections can be made. Voltage can be applied through a center tap of the three or more taps in the auto-transformer. The outer ends of the single winding may be connected to the input terminals 106 where opposite ends of a differential signal enter or leave the voltage protection circuits 110, 112. The magnetic flux in the auto-transformer may be additive and may create a theoretically high impedance to differential signals and allow the differential signals to pass through the auto-transformer. The center tap of the autotransformer can supply voltage to the communication device to which the output terminals 108 are coupled. The auto-transformer can be smaller, lighter and/or cheaper than a standard dual-winding transformer, but may not provide electrical isolation or sufficient common mode energy filtering. The autotransformer can be integrated similarly to the inductive element described earlier within the substrate 102. For example, a ferrite body similar to the ferrite body 126 may be entirely disposed within the substrate 102 and a single conductive coil similar to the conductive coil 122 may be formed to helically wrap around the ferrite body 126.

Figure 7 is another schematic diagram of the capacitive element 600. The capacitive element 600 is shown in Figure 7 in an overcurrent or overvoltage state. When the voltage and/or energy of the current that flows to the capacitive element 600 from the input terminal 106 exceeds a threshold of the capacitive element 600, the vertical height dimension 618 of the stack 606 in the capacitive element 600 increases. The vertical height dimension 618 may increase by a distance that causes the upper electrode 612 to engage the ground plate 614 and, as a result, conductively couple the conductive pathway 608 and the upper electrode 612 with the ground terminal 116 via the ground plate 614.

The vertical height dimension 618 of the stack may increase as shown in Figure 7 by excitation of the piezoelectric layers 602 in the stack 606. For example, the piezoelectric layers 602 may include or be formed from one or more piezoelectric materials that change physical dimensions when electric current is applied to the materials. The number and/or thicknesses of the piezoelectric layers 602, as well as the materials used in the piezoelectric layers 602, may be selected such that when current having a voltage and/or energy at or below a threshold of the capacitive element 600 flows into the stack 606, the piezoelectric layers 602 do not change shape (e.g., increase in size) by a sufficient amount to close the separation gap 616 (shown in Figure 6) and cause the upper electrode 612 to engage the ground plate 614. The piezoelectric layers 602 can change shape (e.g., increase in size) by a sufficient amount when the voltage and/or energy of the current flowing through the stack 606 exceeds the threshold of the capacitive element 600 such that the vertical height dimension 618 of the stack 606 increases and the upper electrode 612 engages the ground plate 614 and shorts the conductive pathway 608 to the ground reference 500.

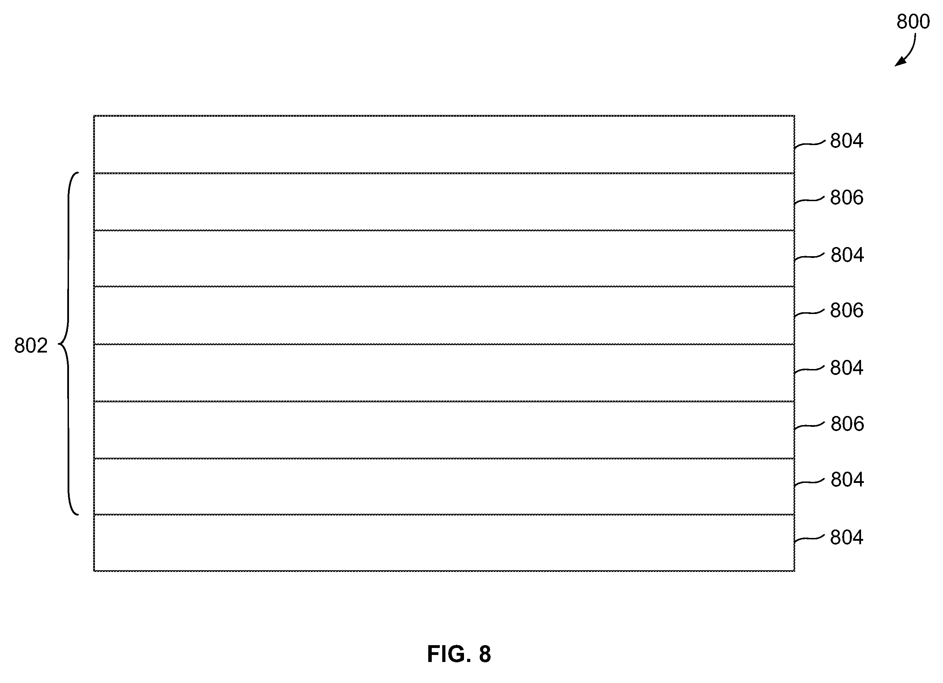

Figure 8 is a schematic diagram of a substrate 800 including an integral capacitive element 802 in accordance with one embodiment. The substrate 800 may be used in place of, or in addition to, the substrate 102 described above in connection with Figure 1. The substrate 800 can be a multilayer printed circuit board (PCB) having multiple layers 804, 806 vertically stacked on each other. The layers 804 can be formed from dielectric materials having relatively high dielectric breakdown voltages. The thickness of the dielectric layers 804 can be approximately 5 to 10 micrometers or more. The layers 806 can be, single-clad metal layers, or dual-clad metal layers. The metal traces on these layers can be provided in predefined locations in the substrate 800 using photolithography/wet etching processes and then laminated to the dielectric layers 804 using various pressure/vacuum/temperature conditions that cause the conductive and dielectric layers 806, 804 to adhere to each other.

The conductive layers may be separated from each other by one or more of the dielectric layers 804 to form the capacitive element 802. The conductive layers of every alternate layer can be conductively coupled with one or more conductive vias and/or traces in or on the substrate 800 to carry current to and/or from the conductive layers thus allow for a multiplate multilayer capacitor. The capacitive element 802 may be used in place of one or more of the capacitive elements 118 (shown in Figure 1). For example, instead of embedding the capacitive elements 118 in the substrate 102, the substrate 800 may be used with the capacitive element 802 integrally formed within the thickness of the substrate 800.

## Claims

1. A voltage protection assembly (100) comprising a planar substrate (102) having a thickness dimension (300) that vertically extends from an upper surface (304) of the substrate to an opposite lower surface (302) of the substrate, the substrate including one or more conductive traces (104), the voltage protection assembly further comprising:
a conductive input terminal (106) conductively coupled with at least one of the conductive traces;
a conductive output terminal (108) conductively coupled with at least one of the conductive traces; and
wherein the output terminal, an inductive element (120), a capacitive element (118, 600), and the input terminal are connected in series by the conductive traces to form a voltage protection circuit (110, 112) that filters one or more frequencies of a data signal transmitted through the voltage protection circuit; and
wherein at least one of the capacitive element (118, 600) and the inductive element (120) are entirely disposed within the thickness dimension (300) of the substrate.

2. The voltage protection assembly of claim 1, wherein the capacitive element (118, 600) is electrically coupled with the input terminal (106) by at least one of the conductive traces, wherein the inductive element (120) conductively coupled with the capacitive element (118, 600) by at least one of the conductive traces, and wherein the conductive output terminal (108) is conductively coupled with the inductive element (120) by at least one of the conductive traces

3. The voltage protection assembly of claim 1 or 2, further comprising a conductive ground terminal (116) conductively coupled with the voltage protection circuit by at least one of the conductive traces, the voltage protection circuit configured to conductively couple the input terminal (106) to the ground terminal (116) when at least one of a voltage or an energy of the data signal flowing through the voltage protection circuit exceeds a first energy threshold.

4. The voltage protection assembly of claim 3, wherein the conductive ground terminal is disposed on the substrate.

5. The voltage protection assembly of claim 3 or 4, wherein the voltage protection circuit comprises an ESD switch (114) for the conductive coupling of the input terminal (106) to the ground terminal (116) when at least one of a voltage or an energy of the data signal flowing through the voltage protection circuit exceeds a first energy threshold.

6. The voltage protection assembly of claim 5, wherein the ESD switch is conductively coupled to the input terminal by the conductive trace connected to the input terminal.

7. The voltage protection assembly of any preceding claim, wherein the capacitive element (600) includes a lower electrode (610) conductively coupled with the input terminal, an upper electrode (612) separated from a ground plate (614) conductively coupled with the ground terminal, a piezoelectric layer (602) disposed between the lower electrode and the upper electrode, and a conductive pathway (608) extending through the piezoelectric layer and coupled with the upper electrode, and further wherein the piezoelectric layer increases in size to cause the upper electrode to engage the ground plate when the at least one of the voltage or the energy of the data signal exceeds a second energy threshold.

8. The voltage protection assembly of any preceding claim, wherein the capacitive element (118, 600) includes a monolithic capacitor entirely disposed within the thickness dimension of the substrate.

9. The voltage protection assembly of any preceding claim, wherein the inductive element includes a ferrite body (126) entirely disposed within the thickness dimension of the substrate, and one or more conductive coils (120) comprising one or more upper conductive layers (200) disposed above the ferrite body, one or more lower conductive layers (314) disposed below the ferrite body, and one or more conductive vias (202) extending through the substrate and conductively coupled with the upper conductive layers and the lower conductive layers.

10. The voltage protection assembly of claim 1, wherein the thickness dimension of the substrate is 2.5 millimeters or less.

11. The voltage protection circuit of any preceding claim, wherein the conductive input and output terminals (106, 108) are disposed on the substrate.
